# EUROPEAN PATENT SPECIFICATION

(11) **EP 1 502 134 B1**
(45) Date of publication and mention of the grant of the patent: **14.03.2007**
(21) Application number: 02745300.0
(22) Date of filing: 26.04.2002
(51) Int. Cl.: G02B 5/32, G11C 13/04

(54) **MULTICHANNEL PARALLEL RECORDING AND READING FOR HYPER LARGE BANDPASS PHOTONICS MEMORY**
MEHRKANALIGES PARALLELES AUFZEICHNEN UND AUSLESEN FÜR PHOTONISCHE SPEICHER MIT HYPERBREITEM BANDPASS
ENREGISTREMENT ET LECTURE PARALLELES MULTICANAUX POUR MEMOIRE PHOTONIQUE A PASSE-BANDE HYPER LARGE

(43) Date of publication of application: 02.02.2005
(73) Proprietor: DISCOVISION ASSOCIATES, Irvine, CA 92614 (US)
(72) Inventor: MEYRUEIS, Patrick, F-67000 Strasbourg (FR); EL HAFIDI, Idriss, F-67100 strasbourg (FR); GRZYMALA, Romualda, F-67000 Strasbourg (FR); FONTAINE, Jo¬l, F-67200 Strasbourg (FR)
(74) Representative: Hirsch & Associés
(86) International application number: PCT/EP2002/005449
(87) International publication number: WO 2003/091770

(56) References cited:
- EP-A- 0 855 717
- WO-A-00/30084
- WO-A-00/75698
- US-A- 5 719 690
- US-A- 6 016 210

## Description

### FIELD OF THE INVENTION

The present invention generally relates to photonics data memory devices. In particular, the present invention relates to parallel recording and reading of photonics data memory.

### BACKGROUND OF THE INVENTION

There is a strong interest in high-capacity data storage systems with fast data access due to an ever-increasing demand for data storage. Limitations in the storage density of conventional magnetic memory devices have led to considerable research in the field of optical memories. Holographic memories have been proposed to supersede the optical disc (compact disc read only memories, or CD-ROMs, and digital video data, or DVDs) as a high-capacity digital storage medium. The high density and speed of holographic memory results from the use of three-dimensional light modulation of the recording material and from the ability to simultaneously read out an entire page of data. The principal advantages of holographic memory are a higher information density, a short random-access time, and a high information transmission rate.

In holographic recording, a light beam from a coherent monochromatic source (e.g., a laser) is split into a reference beam and an object beam. The object beam is passed through a spatial light modulator (SLM) and then into a storage medium. The SLM forms a matrix of cells that modulate light intensity with grey levels. The SLM forms a matrix of shutters that represents a page of binary or grey-level data. The object beam passes through the SLM, which acts to modulate the object beam with binary information being displayed on the SLM. The modulated object beam is directed to one point, after an appropriate beam processing, where it intersects with the reference beam after being routed by an addressing mechanism. It is also contemplated that for multispectral holography, the multispectral hologram may be recorded with more than one wavelength from different lasers or from the same multiline laser at the same time. In other words, the recording can be operating with several wavelengths in the holographic multiplexing process.

An optical system consisting of lenses and mirrors is used to precisely direct the optical beam encoded with the packet of data to the particular addressed area of the storage medium. Optimum use of the capacity of a thick storage medium is realized by spatial and angular multiplexing that can be enhanced by adding frequency polarization, phase multiplexing, etc. In spatial multiplexing, a set of packets is stored in the storage medium and shaped into a plane as an array of spatially separated and regularly arranged subholograms by varying the beam direction in the X-axis and Y-axis of the plane. Each subhologram is formed at a point in the storage medium with the rectangular coordinates representing the respective packet address as recorded in the storage medium. In angular multiplexing, recording is carried out by keeping the X- and Y- coordinates the same while changing the irradiation angle of the reference beam in the storage medium. By repeatedly incrementing the irradiation angle, a plurality of packets of information is recorded as a set of subholograms at the same X- and Y- spatial location.

A volume (thick) hologram requires a thick storage medium, made up of a material sensitive to a spatial distribution of light energy produced by interference of a coherent object light beam and a reference coherent light beam. A hologram may be recorded in a medium as a variation of absorption or phase or both. The storage material responds to incident light patterns causing a change in its optical properties. In a volume hologram, a large number of packets of data can be superimposed, so that every packet of data can be reconstructed without distortion. A volume (thick) hologram may be regarded as a superposition of three-dimensional gratings recorded in the depth of the recording photosensitive material, each satisfying the Bragg law (i.e., a volume phase grating). The grating structures in a volume hologram produce changes in refraction and/or absorption.

While holographic storage systems have not yet replaced current compact disc (CD) and digital video data (DVD) systems, many advances continue to be made which further increase the potential of storage capacity of holographic memories. This includes the use of various multiplexing techniques such as angle, wavelength, phase-code, fractal, peristrophic, and shift. However, methods for recording information in highly multiplexed volume holographic elements, and for reading them out, have not proved satisfactory in terms of throughput, crosstalk, and capacity.

Currently, the recording and reading of the holographic memory is done on one point of the recording plate at a time (i.e., sequentially). For fast recording and reading processes, parallel recording and reading of multiple points (e.g., a matrix of points) is provided.

Document WO-A-0075698 discloses an holographic display with a matrix of displays and a matrix of micro-lenses.

### BRIEF DESCRIPTION OF THE DRAWINGS

In order to facilitate a fuller understanding of the present invention, reference is now made to the appended drawings. These drawings should not be construed as limiting the present invention, but are intended to be exemplary only.
Figure 1 is a schematic representation of an apparatus for providing expanded beams to a recording system in accordance with one embodiment of the invention.
Figure 2 is a schematic representation of an apparatus for recording multiple interference patterns simultaneously in accordance with one embodiment of the invention.
Figure 3 is a schematic representation of an apparatus for reading multiple interference patterns simultaneously.

### DETAILED DESCRIPTION OF THE INVENTION

A recording system in the present invention comprises a laser, a storage layer, a matrix of SLMs and a matrix of focusing lenses. A reading system, which is assembled to read data from the diffractive optics memory by emitting a read (e.g., reference) beam onto the memory, comprises the diffractive optics memory and a matrix of CCDs. The diffractive optics memory has information stored therein, located at a plurality of points on the memory. At one angle, a plurality of packets of information is formed on a matrix of points on the diffractive optics memory. At another angle, another plurality of packets is formed at a different matrix of points on the memory. The present invention introduces the use of a matrix of SLMs in a recording system and a matrix of CCDs in a reading system to simultaneously store and read information on a matrix of points of a recording plate respectively. Furthermore, the present invention uses a large collimated object beam and a large reference beam, in the recording system, that can cover the matrix of points of the recording plate (i.e., the diffractive optics memory). In the reading system, a large read beam (e.g., reference beam) is used for reading the information from the matrix of points of the recording plate.

Further advantages and novel features of the present invention will become apparent to those skilled in the art from this disclosure, including the following detailed description, as well as by practice of the invention. While the invention is described below with reference to illustrative embodiments, this description is not intended to be construed in a limiting sense. Those of ordinary skill in the art having access to the teachings herein will recognize additional implementations, modifications, and embodiments, as well as other fields of use, which are within the scope of the invention as disclosed and claimed herein, and with respect to which the invention could be of significant utility.

### Storing/Recording Phase

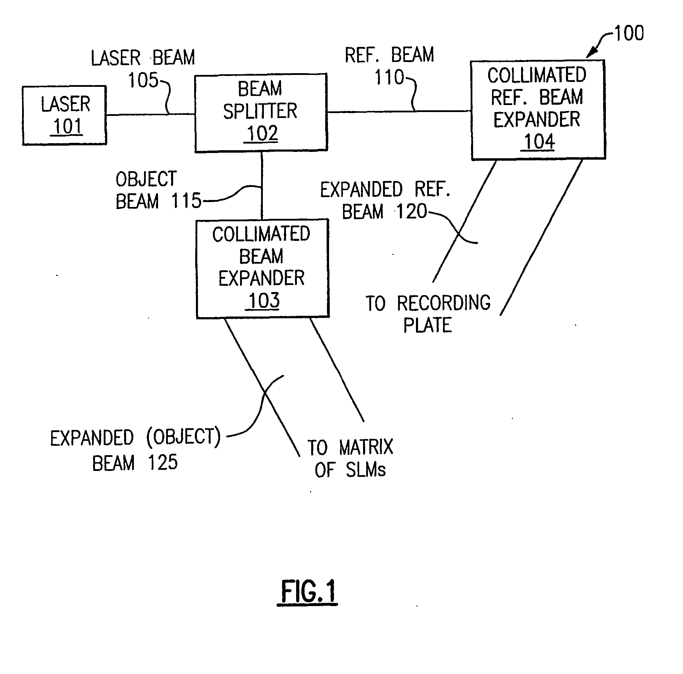

FIG. 1 is a schematic representation of a system 100 for recording multiple interference patterns in accordance with one embodiment of the invention. The system 100 comprises a laser 101, a beam splitter 102, a collimated beam expander 103, and a collimated reference beam expander 104. In a recording phase, the laser 101 provides a laser beam 105 (i.e., coherent light beam) to the beam splitter system 102. The laser 101 may be a YAG doubled laser (i.e., a solid state laser) where a rod of YAG material emits laser light in the infrared to the laser. The laser beam 105 emanating from laser 101 is split into a reference beam 110 and an object beam 115.

The collimated beam expander 103 expands the object beam 115 and produces an expanded object beam 125. The expanded object beam 125 is expanded to fit the matrix of SLMs. The reference beam expander 104 expands the reference beam 110 and produces an expanded reference beam 120. The expanded object beam 125 passes through a matrix of SLMs (e.g., displays), which acts to modulate the expanded object beam 125 to produce a plurality of object beams, which carry binary information. In one embodiment, the number of SLMs in the matrix of SLMs corresponds to the number of object beams, which also corresponds to the number of matrix of points on the recording plate (see FIG. 2). The expanded reference beam 120 is expanded to fit the matrix of points of the recording plate.

FIG. 2 is a schematic representation of a system 200 for recording multiple interference patterns in accordance with one embodiment of the invention. The system 200 includes a matrix of SLMs 201, a matrix of focusing lenses 202, and a recording plate 205. As stated above, the expanded object beam 125 passes through the matrix of SLMs 201 and produces a matrix of object beams 203. The matrix of focusing lenses 202 focuses the corresponding matrix of object beams 203 to the matrix of points on the recording plate 205. The expanded reference beam 120 interferes with the matrix of object beams 203 to form the interference patterns, which are stored in the matrix of points on the recording medium due to the perturbation in the refractive index. Thus, holograms are stored, on the matrix of points, at a unique angle of the expanded reference beam 120. The separation between the various holograms stored within the same volume relies on the coherent nature of the hologram, in order to allow its retrieval in phase with the volume only for a defined angle value.

It is contemplated that the memory device 205 has a plurality of cells to hold the recorded information. The memory device 205 is a holographic memory device that contains information stored during a phase of storing information. The memory device 205 is typically a three-dimensional body made up of a material sensitive to a spatial distribution of light energy produced by interference of the matrix of object beams 203 and the expanded reference light beam 120. Holograms may be recorded in the medium 205 as a variation of absorption or phase or both. The storage material responds to incident light patterns, causing the change in its optical properties. In a volume (thick) hologram, a large number of packets of data can be superimposed, so that every packet of data can be reconstructed without distortion. The volume hologram may be regarded as a superposition of three-dimensional gratings recorded in the depth of the layer of the recording material, each satisfying the Bragg law (i.e., a volume phase grating). The grating structures in a volume hologram produce changes in refraction and/or absorption. Each of a plurality of points on the matrix of points is defined by its rectilinear coordinates (X,Y). An image-forming system (not shown) reduces the matrix of object beams 203 to a plurality of sub-holograms each having a minimum size at one of the X,Y points of the matrix of points. A point in physical space, defined by its rectilinear coordinates, contains a plurality of packets.

In one embodiment, the memory device 205 is constructed of organic material, such as a polypeptide material, and made in accordance with the techniques described in the co-pending patent application entitled "Photonics Data Storage System Using a Polypeptide Material and Method for Making Same," Serial No. PCT/FR01/02386, which is herein incorporated by reference.

A display in the matrix of displays 201 may be any device for displaying data packets in a system, such as spatial light modulators (SLMs) or liquid crystal light valves (LCLVs). The plurality of bits represented on the display screen of the display is presented as a two-dimensional pattern of transparent and opaque pixels (i.e., data packet). The data packet displayed is derived from any source such as a computer program, the Internet, and so forth. In an internet storage application, the packets displayed may be formatted similarly to the packets of the internet.

When the matrix of object beams 203 passes through the matrix of displays 201, the display acts to modulate the matrix of object beams 203 with the binary information. The matrix of object beams 203 is then directed to a defined matrix of points on the recording medium 205 where these object beams intersect with the expanded reference beam 120 to create a plurality of interference patterns loaded with data packets. The matrix of lenses 202 may be used to converge the modulated matrix of object beams 203 and to focus the beams to the recording medium 205. In other words, the modulated object beams become reduced by means of the lenses in the matrix of lenses 202 so that the matrix of points of convergence of the modulated object beams lie slightly beyond the recording medium 205. The expanded reference beam 120 is positioned at different angles by the angular multiplexing method so that a plurality of data packets is recorded at the matrix of points of the recording medium 205.

As stated above, the recording system 100 includes the expanded reference beam 120, the matrix of object beams 203, and the recording medium 205. The expanded reference beam 120 and the object beams in the matrix of object beams 203 intersect to form patterns to be recorded on the recording medium 205 at a matrix of X,Y locations. The expanded reference beam 120 is angularly modified sequentially so that different data can be recorded on a different matrix of points with different angles on the recording medium 205. The expanded reference beam 120 is also spatially changed so that data can be recorded on a different matrix of points of the recording medium 101. This is the spatial multiplexing that is carried out by sequentially changing the rectilinear coordinates. Angular multiplexing is achieved by varying the angle of the expanded reference beam 120 with respect to the surface plane of the storage medium 205. In other words, angular multiplexing is carried out by sequentially changing the angle of the expanded reference beam 120. Multiple packets of information are recorded in the storage medium 205 as a matrix of diffraction patterns (e.g., matrix of sub-holograms) for each selected angle and spatial location. Spatial multiplexing is achieved by shifting the expanded reference beam 120 with respect to the surface of the storage medium 205 so that a matrix of points shifts to another spatial location. A matrix of data packets may be reconstructed by shining the expanded reference beam 120 at the same angle and spatial location at which the matrix of data packets was recorded. The portion of the expanded reference beam 120 diffracted by the storage medium material forms the reconstruction, which is typically detected by a detector array. The storage medium 205 may be mechanically shifted in order to store data packets at a different matrix of points by their coordinates (X,Y).

The storage medium 205 is arranged in matrices. Each of a plurality of points on the matrix is defined by its rectilinear coordinate's signals involved in recording a diffraction pattern (i.e., a hologram) in a storage medium using angular and spatial multiplexing. Various diffractive recording processes have been developed in the art, and further details can be found in the book *Holographic Data Storage* by H.J. Coufal, D. Psaltis, and G.T. Sincerbox (Springer 2000). It is contemplated that a storage diffractive patterns matrix, in some cases, can also be implemented by using techniques other than the interference of a reference and object beam, such as using an e-beam and a microlithography process for etching materials to generate diffractive structures.

### Reading Phase

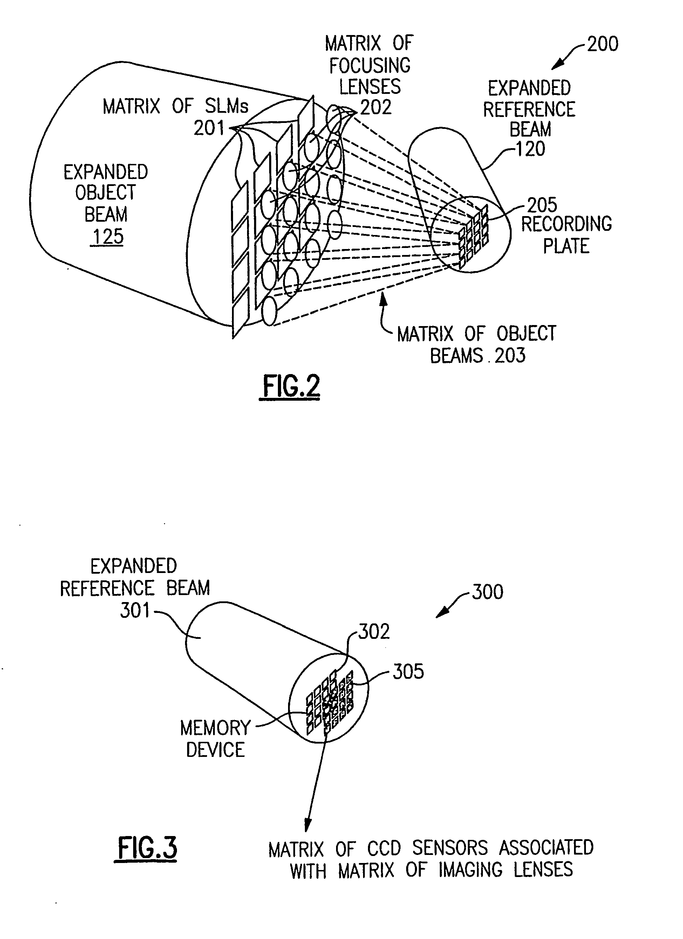

FIG. 3 is a schematic representation of an unclaimed apparatus for reading multiple interference patterns simultaneously. The reading apparatus 300 includes the laser 101, the memory device (i.e., recording medium) 205, and a matrix of sensing devices (e.g., CCD cameras) 305. Each sensing device may be a solid-state chip produced by microlithography and includes micromechanical electronics and photonics.

Retrieving the recorded/stored information from the recording medium 205 requires the use of a reference beam (i.e., read beam) whose characteristics correspond to those employed for writing or for storage. The reference beam induces diffraction due to perturbation in the refractive index modulation corresponding to the characteristics of the recording beams, thereby creating a data loaded modulated beam. The reading angle values in the reading procedure are similar to those of the writing procedure in that they both use the same principles of nodal points. The reading procedure may be carried out with a greater degree of tolerance than the recording procedure. However, the laser source used for reading may not be as powerful as the laser source used for recording.

The reference beam is positioned in order to access a plurality of data packets contained at a defined matrix of points (X _{M},Y _{N}, where M and N are positive integers) in the recorded medium 205. In one embodiment, M equals N. The reading procedure is similar in the addressing angle values to the writing or recording procedure. However, the reading procedure may be carried out with a greater degree of tolerance than the recording procedure. It is possible to use a very compact laser source of a solid-state type for the reading process because the laser power necessary for reading is much lower than the one for recording.

Data packets are reconstructed by shining the expanded reading beam 301 (i.e. reference beam) at the same angle and spatial location in which the data packets were recorded. The expanded reading beam 301 may be the same as the expanded reference beam 120 as shown in FIG. 1. It is contemplated that the data packets are recorded simultaneously on a matrix of points of the recording plate 205 at the recording stage. The portion of the expanded reading beam 301 diffracted by the diffractive memory matrix forms the reconstruction, which is typically detected by the matrix of CCDs.

The reading apparatus 300 may also include dynamic devices (e.g., actuators, micromirrors, etc.) that shape and direct the expanded reading beam 301 generated by the laser 101 at a position and angle onto the matrix of points of the recording plate 205. A computer (not shown) may be used to control the dynamic devices.

Each of the sensing devices in the matrix of sensing devices 305 may be any sensor that can sense the images from a matrix of output beams 302. The sensing device may be made of CCD or CMOS (complementary metal-oxide-semiconductor) active pixel sensors (APS). In one embodiment, the sensing device is a charge-coupled diode.

The matrix of output of beams 302, which contains a plurality of output pages carrying data/information in the memory device, is created by the expanded reading beam 302. The plurality of data packets from the matrix of points in the recording medium 205 are reconstructed simultaneously by shining the expanded reference beam (i.e., read beam) 301 at the same location in which the data packets were recorded. The expanded reference beam 301 diffracted by the recording medium 205 forms the reconstruction of the matrix of stored data packets, which are detected by the matrix of sensing devices 305. The expanded reference beam 301 is configured to address the plurality of packets at different locations in the recording medium 205. The digital output of the matrix of image sensors 305 is further processed by a computer (not shown).

The present invention is not to be limited in scope by the specific embodiments described herein. Indeed, this application is intended to cover any modifications of the present invention, in addition to those described herein, and the present invention is not confined to the details which have been set forth. Thus, the scope of the invention should be determined by the appended claims and their legal equivalents, rather than by the examples given.

## Claims

1. An apparatus comprising:
means for providing a reference beam and object beam;
a matrix of displays for displaying binary information for modulating said object beam into a plurality of sub-object beams with the binary information; and
a matrix of microlenses for focusing the plurality of sub-object beams onto a recording plate wherein the plurality of sub-object beams intersect said reference beam to create holograms on a matrix of points of the recording plate for parallel recording on said points.

2. The apparatus of claim 1 wherein the holograms represent packets of data.

3. The apparatus of claim 1 wherein the object beam and the reference beam are split from a light beam emitted from a light source by a beam splitter.

4. The apparatus of claim 3 wherein the beam splitter is a reflective beam splitter with a power ratio of approximately 50/50.

5. The apparatus of claim 1 wherein the object beam is collimated.

6. The apparatus of claim 1 further comprising an expander for expanding the object beam and the reference beam to illuminate the beams to fit the matrix of displays and the matrix of points on the recording plate respectively.

7. The apparatus of claim 6 wherein the expander includes at least two lenses for expanding and collimating the beams.

8. The apparatus of claim 5 wherein the expander includes a filter for filtering the micronic hole to remove noise coming from the light beam.

9. The apparatus of claim 1 wherein the recording plate is made of polypeptide material.

10. The apparatus of claim 1 wherein the reference beam is angularly multiplexed to record different packets of data organized in a form of matrix of points.

11. The apparatus of claim 1 wherein the reference beam is spatially multiplexed to record different packets of data onto a different matrix of points.

12. The apparatus of claim 1 wherein the matrix of displays is a matrix of SLMs.

13. The apparatus of claim 1 wherein the matrix of displays, the matrix of microlenses and the matrix of points are at least a 1 by 2 or 2 by 1 matrix.

14. A method comprising:
providing a reference beam and an object beam;
displaying binary information on a plurality of sub-object beams using a matrix of displays, the sub-object beam being divided from the object beam; and
focusing the sub-object beams onto a recording plate using a matrix of microlenses, the plurality of sub-object beams intersecting the reference beam to create holograms on a matrix of points of the recording plate for parallel recording on said points.

15. The method of claim 14 further comprising splitting a laser beam to produce the reference beam and the object beam.

16. The method of claim 14 further comprising collimating the object beam.

17. The method of claim 14 further comprising expanding the object and reference beams to fit the matrix of displays and a matrix of points respectively.

18. The method of claim 17 wherein the expanding includes filtering a micronic hole to remove noise coming from the reference and object beams.

19. The method of claim 14 wherein the recording is made of polypeptide material.

20. The method of claim 14 further comprising angularly multiplexing the reference beam to record different data packets onto the matrix of points.

21. The method of claim 14 further comprising spatially multiplexing the reference beam to record different data packets onto a different matrix of points.

## Patentansprüche

1. Vorrichtung, die folgendes aufweist:
Mittel zur Bereitstellung eines Bezugsstrahls und eines Objektstrahls;
eine Anzeigematrix zum Anzeigen von binären Informationen zur Modulierung des Objektstrahls in eine Vielzahl von Sub-Objektstrahlen mit den binären Informationen; und
eine Mikrolinsenmatrix zur Fokussierung der Vielzahl von Sub-Objektstrahlen auf eine Aufzeichnungsplatte, wobei die Vielzahl von Sub-Objektstrahlen den Bezugsstrahl kreuzt, um Hologramme auf einer Punktmatrix der Aufzeichnungsplatte für eine parallele Aufzeichnung auf diesen Punkten zu erzeugen.

2. Vorrichtung nach Anspruch 1, wobei die Hologramme Datenpakete darstellen.

3. Vorrichtung nach Anspruch 1, wobei der Objektstrahl und der Bezugsstrahl durch einen Strahlteiler von einem Lichtstrahl abgeteilt werden, der von einer Lichtquelle emittiert wird.

4. Vorrichtung der Anspruch 3, wobei der Strahlteiler ein reflektierender Strahlteiler mit einem Leistungsverhältnis von etwa 50/50 ist.

5. Vorrichtung nach Anspruch 1, wobei der Objektstrahl kollimiert ist.

6. Vorrichtungen nach Anspruch 1, die ferner einen Aufweiter einschließt, um den Objektstrahl und den Bezugsstrahl aufzuweiten, um die Strahlen so abzustrahlen, dass sie jeweils für die Anzeigematrix und die Punktmatrix auf der Aufzeichnungsplatte passen.

7. Die Vorrichtung nach Anspruch 6, wobei der Aufweiter mindestens zwei Linsen zum Aufweiten und Kollimieren der Strahlen einschließt.

8. Vorrichtung nach Anspruch 5, wobei der Aufweiter ein Filter zur Filterung der mikrofeinen Öffnung einschließt, um Rauschen, das vom Lichtstrahl ausgeht, zu entfemen.

9. Vorrichtung nach Anspruch 1, wobei die Aufnahmeplatte aus Polypeptidmaterial gefertigt ist.

10. Vorrichtung nach Anspruch 1, wobei der Bezugsstrahl winkelmäßig gemultiplext wird, um verschiedene Datenpakete organisiert in Form einer Punktematrix aufzuzeichnen.

11. Vorrichtung nach Anspruch 1, wobei der Bezugsstrahl räumlich gemultiplext wird, um andere Datenpakete auf einer anderen Punktematrix aufzuzeichnen.

12. Vorrichtung nach Anspruch 1, wobei die Anzeigematrix eine SLMs-Matrix ist.

13. Vorrichtung nach Anspruch 1, wobei die Anzeigematrix, die Mikrolinsenmatrix und die Punktmatrix mindestens eine 1 mal 2- oder 2 mal 1-Matrix sind.

14. Verfahren, das folgendes umfasst:
Bereitstellen eines Bezugsstrahls und eines Objektstrahls;
Anzeigen binärer Informationen auf einer Vielzahl von Sub-Objektstrahlen unter Verwendung einer Anzeigematrix, wobei die Sub-Objektstrahlen von dem Objektstrahl abgeteilt sind; und
Fokussieren der Sub-Objektstrahlen auf eine Aufreichnungsplatte mittels einer Mikrolinsenmatrix, wobei die Sub-Objektstrahlen den Bezugsstrahl schneiden, um Hologramme auf einer Punktematrix der Aufzeichnungsplatte für die parallele Aufzeichnung auf diesen Punkten zu erzeugen.

15. Verfahren nach Anspruch 14, das ferner das Teilen eines Laserstrahls umfasst, um den Bezugsstrahl und den Objektstrahl zu erzeugen.

16. Verfahren nach Anspruch 14, das ferner die Kollimierung des Objektstrahls umfasst.

17. Verfahren nach Anspruch 14, das ferner die Aufweitung der Objekt- und Bezugsstrahlen, um sie an eine Anzeigematrix bzw. eine Punktmatrix anzupassen, umfasst.

18. Verfahren nach Anspruch 17, wobei die Aufweitung die Filterung einer mikrofeinen Öffnung einschließt, um Rauschen zu entfernen, das von den Bezugs- und Objektstrahlen ausgeht.

19. Verfahren nach Anspruch 14, wobei die Aufzeichnung aus Polypeptidmaterial gefertigt wird.

20. Verfahren nach Anspruch 14, das ferner die winkelmäßige Multiplexierung des Lesestrahls, um einen anderen Satz von Datenpaketen auf der Punktematrix aufzuzeichnen, umfasst.

21. Verfahren nach Anspruch 14, das ferner die räumliche Multiplexierung des Lesestrahls, um einen anderen Satz von Datenpaketen auf einer anderen Punktematrix aufzuzeichnen, umfasst.

## Revendications

1. Dispositif comprenant :
- un moyen destiné à fournir un faisceau de référence et un faisceau objet;
- un réseau d'afficheurs destinés à afficher des informations binaires afin de moduler ledit faisceau objet en une pluralité de sous-faisceaux objet avec les informations binaires ; et
- un réseau de micro-lentilles destinées à concentrer la pluralité de sous-faisceaux objet vers une plaque d'enregistrement sur laquelle la pluralité de sous-faisceaux objet croise ledit faisceau de référence afin de créer des hologrammes sur un réseau de points de la plaque d'enregistrement en vue d'un enregistrement parallèle sur lesdits points.

2. Dispositif selon la revendication 1, dans lequel les hologrammes représentent des paquets de données.

3. Dispositif selon la revendication 1, dans lequel le faisceau objet et le faisceau de référence sont séparés à partir d'un faisceau lumineux émis par une source de lumière par un séparateur de faisceau.

4. Dispositif selon la revendication 3, dans lequel le séparateur de faisceau est un séparateur de faisceau réfléchissant ayant un rapport de puissance d'environ 50/50.

5. Dispositif selon la revendication 1, dans lequel le faisceau objet est collimaté.

6. Dispositif selon la revendication 1, comprenant en outre un développeur destiné à développer le faisceau objet et le faisceau de référence afin d'éclairer les faisceaux de façon à faire correspondre respectivement le réseau d'afficheurs et le réseau de points sur la plaque d'enregistrement.

7. Dispositif selon la revendication 6, dans lequel le développeur comprend au moins deux lentilles destinées à développer et collimater les faisceaux.

8. Dispositif selon la revendication 5, dans lequel le développeur comprend un filtre destiné à filtrer le trou micronique de façon à éliminer le bruit provenant du faisceau lumineux.

9. Dispositif selon la revendication 1, dans lequel la plaque d'enregistrement est constituée d'un matériau de polypeptide.

10. Dispositif selon la revendication 1, dans lequel le faisceau de référence est multiplexé de manière angulaire afin d'enregistrer différents paquets de données organisés sous la forme d'un réseau de points.

11. Dispositif selon la revendication 1, dans lequel le faisceau de référence est multiplexé spatialement afin d'enregistrer différents paquets de données sur un réseau différent de points.

12. Dispositif selon la revendication 1, dans lequel le réseau d'afficheurs est un réseau de SLM.

13. Dispositif selon la revendication 1, dans lequel le réseau d'afficheurs, le réseau de micro-lentilles et le réseau de points sont au moins un réseau de 1 sur 2 ou de 2 sur 1.

14. Procédé comprenant :
- le fait de prévoir un faisceau de référence et un faisceau objet ;
- l'affichage d'informations binaires sur une pluralité de sous-faisceaux objet en utilisant un réseau d'afficheurs, le sous-faisceau objet étant divisé du faisceau objet ; et
- la focalisation des sous-faisceaux objet sur une plaque d'enregistrement en utilisant un réseau de micro-lentilles, la pluralité de sous-faisceaux objet croisant le faisceau de référence afin de créer des hologrammes sur un réseau de points de la plaque d'enregistrement en vue d'un enregistrement parallèle sur lesdits points.

15. Procédé selon la revendication 14, comprenant en outre la séparation d'un faisceau laser afin de produire le faisceau de référence et le faisceau objet.

16. Procédé selon la revendication 14, comprenant en outre la collimation du faisceau objet.

17. Procédé selon la revendication 14, comprenant en outre le développement des faisceaux d'objet et de référence afin de faire correspondre respectivement le réseau d'afficheurs et un réseau de points.

18. Procédé selon la revendication 17, dans lequel le développement comprend le filtrage d'un trou micronique afin d'éliminer le bruit provenant des faisceaux de référence et d'objet.

19. Procédé selon la revendication 14, dans lequel l'enregistrement est constitué d'un matériau de polypeptide.

20. Procédé selon la revendication 14, comprenant en outre le multiplexage angulaire du faisceau de référence afin d'enregistrer différents paquets de données sur le réseau de points.

21. Procédé selon la revendication 14, comprenant en outre le multiplexage spatial du faisceau de référence afin d'enregistrer différents paquets de données sur un réseau différent de points.
